# EUROPÄISCHE PATENTSCHRIFT

(11) **EP 2 342 824 B1**
(45) Veröffentlichungstag und Bekanntmachung des Hinweises auf die Patenterteilung: **20.08.2014**
(21) Anmeldenummer: 08875277.9
(22) Anmeldetag: 05.11.2008
(51) Int. Cl.: H03K 17/082, H03K 17/16, H02H 7/122

(54) **VOR KURZSCHLUSS GESCHÜTZTE HALBBRÜCKENSCHALTUNG MIT HALBLEITERSCHALTERN**
HALF-BRIDGE CIRCUIT PROTECTED AGAINST SHORT CIRCUITS AND HAVING SEMICONDUCTOR SWITCHES
CIRCUIT EN DEMI-PONT PROTÉGÉ CONTRE LES COURTS-CIRCUITS AVEC COMMUTATEURS SEMICONDUCTEURS

(43) Veröffentlichungstag der Anmeldung: 13.07.2011
(73) Patentinhaber: OSRAM GmbH, 80807 München (DE)
(72) Erfinder: HECKMANN, Markus, 81479 München (DE)
(86) Internationale Anmeldenummer: PCT/EP2008/064972
(87) Internationale Veröffentlichungsnummer: WO 2010/051836

(56) Entgegenhaltungen:
- WO-A-2004/008601
- DE-A1- 10 035 387
- US-A1- 2002 118 500
- US-B1- 6 304 472

## Beschreibung

### Technisches Gebiet

Die Erfindung betrifft eine Schaltungsanordnung gemäß dem Oberbegriff des Patentanspruchs 1.

### Stand der Technik

Halbbrückenschaltungen sind als solche bekannt: Zwei Schalter sind hierbei zwischen einem ersten Potentialanschluss und einem zweiten Potentialanschluss, der typischerweise an Massepotential liegt, in Reihe geschaltet. Durch Steuerung der Schalter kann das Potential, das zwischen den beiden Schaltern anliegt, beeinflusst werden. Es ist bekannt, derartige Halbbrückenschaltungen mit Halbleiterschaltern und insbesondere Transistoren als Schaltern bereitzustellen.

Aufgrund von Fehlsteuerungen und Fehlfunktionen kann es in der Schaltung zu Kurzschlüssen kommen. Die relativ großen Kurzschlussströme können die Halbleiterschalter hierbei dauerhaft beschädigen.

Aus der US 6 304 472 B1 ist eine Halbbrücke in einer Schaltungsanordnung bekannt, bei der der Strom durch die Halbbrücke mittels einer Induktivität gemessen wird, und bei zu hohem Stromwert mindestens ein Schalter der Halbbrücke abgeschaltet wird.

### Darstellung der Erfindung

Die Aufgabe der vorliegenden Erfindung ist es, eine Schaltungsanordnung gemäß dem Oberbegriff des Patentanspruchs 1 bereitzustellen, bei der die Halbleiterschaltern besonders wirksam vor Beschädigung durch Kurzschlüsse geschützt sind.

Diese Aufgabe wird bei einer Schaltungsanordnung mit Merkmalen des Oberbegriffs des Patentanspruchs 1 durch die Merkmale des kennzeichnenden Teils des Patentanspruchs 1 gelöst.

Erfindungsgemäß ist somit in der Schaltungsanordnung ein induktives Element in der Reihenschaltung zwischen den beiden Potentialanschlüssen, in der Regel also irgendwo zwischen einem Halbleiterschalter der (Halbbrücken-) Schaltung und einem der Potentialanschlüsse, bereitgestellt. Ferner gibt es Elemente einer Wirkkette derart, dass bei vorbestimmten Bedingungen eine an dem induktiven Element abfallende Spannung ein Ausschalten zumindest eines der Halbleiterschalter, also ein Sperren zumindest eines der Transistoren, bewirkt.

Das Bereitstellen des induktiven Elements trägt der Tatsache Rechnung, dass bei Auftreten eines Kurzschlusses der über die Reihenschaltung von dem ersten zum zweiten Potentialanschluss fließende Strom kurzfristig stark ansteigt. Ein Anstieg im Strom bewirkt einen Abfall an einer Spannung an dem induktiven Element, die dann ausgewertet wird.

Man kann die Wirkkette formal in einzelne funktionale Mittel aufteilen. Zum Beispiel kann man formulieren, dass es Mittel zum Auswerten einer an dem induktiven Element abfallenden Spannung hinsichtlich zumindest eines vorbestimmten Kriteriums gibt, und dass es Mittel zum Sperren zumindest eines der Halbleiterschalter der Halbbrücke bei Erfülltsein eines vorbestimmten Kriteriums gibt. Derartige Mittel können insbesondere Mikrocontroller umfassen. Ein Mikroprozessor kann als Mittel zum Auswerten die an dem induktiven Element abfallende Spannung insbesondere in ihrem Zeitverlauf auswerten. Ein Sperren insbesondere eines Transistors kann vorgesehen sein, wenn der Zeitverlauf bestimmten Bedingungen genügt, und hierbei können dann unterschiedliche Szenarien berücksichtigt werden. Ein anderer Mikroprozessor kann dann Steuerbefehle an die Steueranschlüsse des zu sperrenden Transistors senden, nachdem er ein entsprechendes Informationssignal von den Mitteln zum Auswerten erhalten hat. Es kann auch ein und derselbe Mikroprozessor gleichzeitig als Mittel zum Auswerten und Mittel zum Sperren dienen.

Neben den bereits erwähnten Mikrocontrollern bzw. Mikroprozessoren ist es besonders vorteilhaft, lediglich elektronische Bauteile in einer Wirkkette vorzusehen, so dass ein Auswerten der abfallenden Spannung lediglich implizit erfolgt.

Im einfachsten Fall wird man davon ausgehen, dass die Änderung der Stromstärke einen vorbestimmten Schwellwert überschreiten muss. Dieser entspricht einem Schwellwert für die an dem induktiven Element abfallende Spannung. Eine schwellwertabhängige Schaltung macht erfindungsgemäß Gebrauch von einer Zenerdiode. An einer Zenerdiode kann bis zur Zenerspannung eine Spannung anliegen, ohne dass Strom fließt. Bei Überschreiten der Zenerspannung kommt es spontan zum Fließen eines starken Stromes. Dieser Strom kann im Rahmen der Wirkkette genutzt werden. Die Wirkkette umfasst erfindungsgemäß einen Hilfstransistor. Da Transistoren über eine Spannung steuerbar sind, kann der über die Zenerdiode fließende Strom über ein Widerstandselement geleitet werden. Somit erhält man eine zuverlässige Steuerung, wenn eine Reihenschaltung aus der Zenerdiode und einem Widerstandselement parallel zu dem induktiven Element geschaltet ist, während die beiden Anschlüsse des Widerstandselements mit zwei Anschlüssen eines ersten Hilfstransistors gekoppelt sind, darunter insbesondere dem Steueranschluss. Dann wird durch eine an dem Widerstandselement abfallende Spannung ein Durchschalten des ersten Hilfstransistors bestimmt. Unterhalb eines zum Hilfstransistor definierten Schwellwerts (typischerweise 0,7 V) für die an dem Widerstandselement abfallende Spannung sperrt der erste Hilfstransistor oberhalb des Schwellwerts schaltet er durch.

Beim Durchschalten des ersten Hilfstransistors kann dieser unmittelbar auf einen Transistor aus der Halbbrückenschaltung einwirken und diesen zum Sperren bringen.

Da die an dem induktiven Element abfallende Spannung lediglich ein Maß für die Änderung der Stromstärke ist, und nicht für deren absoluten Wert, kann es sich als vorteilhaft erweisen, den Zeitverlauf der Spannung zu berücksichtigen. Erfindungsgemäß wird dies dadurch bewirkt, dass die Wirkkette ein Zeitglied umfasst.

Ein Zeitglied umfasst in einem einfachen Fall einfach ein kapazitives Element (einen Kondensator), der aufgeladen wird. Bei der oben genannten erfindungsgemäßen Schaltungsanordnung mit Zenerdiode, Widerstandselement und erstem Hilfstransistor ist vorgesehen, dass einer der beiden Anschlüsse des ersten Hilfstransistors (z. B. dessen Kollektoranschluss) mit einem Potentialanschluss gekoppelt ist, und dass ein weiterer Anschluss des ersten Hilfstransistors (insbesondere nicht der Basisanschluss, also der Steueranschluss, sondern bevorzugt der Emitteranschluss) über ein kapazitives Element mit einem weiteren Potentialanschluss gekoppelt ist. Dann geschieht Folgendes: Bei Anlegen einer Spannung an die Potentialanschlüsse (z. B. durch Anlegen eines Potentials an einen der Potentialanschlüsse und Erden des anderen Potentialanschlusses) fließt ein Strom über den ersten Hilfstransistor, wenn dieser durchschaltet. Dieser Strom lädt dann das kapazitive Element. Nun lässt sich das kapazitive Element mit seinen beiden Anschlüssen mit jeweiligen Anschlüssen eines zweiten Hilfstransistors koppeln, so dass durch eine an dem kapazitiven Element abfallende Spannung ein Durchschalten des zweiten Hilfstransistors bestimmt wird. Werden beispielsweise Gate und Source eines MOSFETs als zweitem Hilfstransistor mit einem Kondensator gekoppelt, so schaltet selbiger oberhalb eines Schwellwerts für die an dem Kondensator abfallende Spannung durch. Werden nun die von dem Gate-Anschluss verschiedenen Anschlüsse des zweiten Hilfstransistors zum Kurzschließen des Steueranschlusses eines von zwei Transistoren als Halbleiterschaltern der Halbbrückenschaltung mit einem der anderen Anschlüsse verwendet, so sperrt dieser Transistor der Halbbrückenschaltung wunschgemäß.

Die Verwendung der elektronischen Bauelemente in der genannten Art bewirkt einerseits ein schnelles Abschalten bereits während des Entstehens großer Kurzschlussströme, andererseits wird auch bei einem relativ langsamen Entstehen von Kurzschlussströmen rechtzeitig einer der beiden Halbleiterschalter der Halbbrückenschaltung ausgeschaltet.

Durch geeignete Wahl der Größen können die vorbestimmten Kriterien festgelegt werden, bei denen ein Sperren erfolgt. Das induktive Element sollte eine Induktivität von zwischen 10 nH und 500 nH haben, typischerweise wird man einen Wert von einigen 100 nH wählen. Die Zenerspannung der Zenerdiode kann zwischen 2 V und mehreren 100 V liegen z. B. bei 33 V. Induktivität und Zenerspannung können passend zu dem vorbestimmten Kriterium gewählt sein. Es kann vorgesehen sein, dass ab mehr als 50 A/µs Stromanstieg die Wirkkette zu laufen beginnt. Typischerweise folgt eine Auslösung einer Wirkkette jedoch erst bei einem Stromanstieg von zwischen 100 und 1000 A/µs.

Die genaue Wahl der Größen ist von der vorgesehenen Sperrverzugszeit ("reverse recovery time") und den zu erwartenden Lastströmen in der Schaltung abhängig.

### Kurze Beschreibung der Zeichnung(en)

Im Folgenden soll die Erfindung anhand eines Ausführungsbeispiels näher erläutert werden. Es zeigt:
- Fig. 1: eine teilweise schematische Darstellung einer erfindungsgemäßen Schaltungsanordnung und
- Fig. 2: eine konkrete Ausführungsform einer erfindungsgemäßen Schaltungsanordnung

### Bevorzugte Ausführung der Erfindung

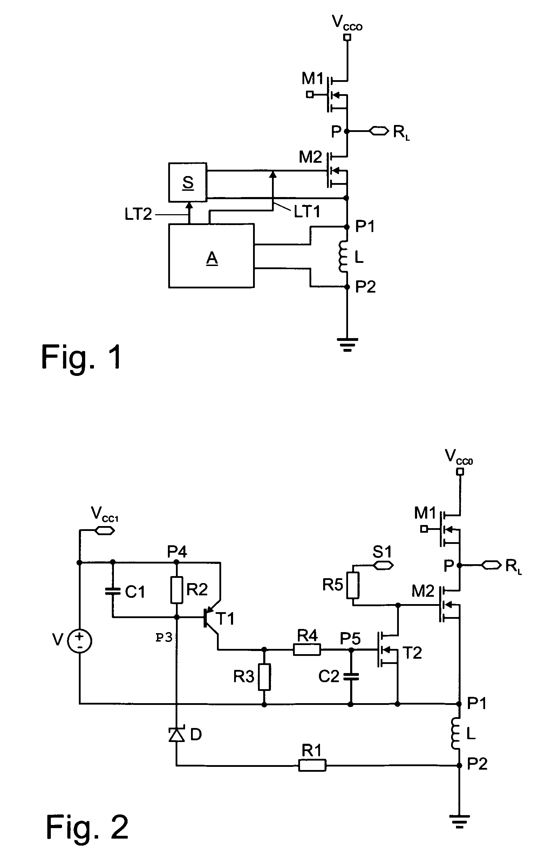

Fig. 1 und 2 zeigen Halbbrückenschaltungen, in denen als Schalter Transistoren, vorliegend MOSFETs M1 und M2 eingesetzt sind. Eine Halbbrückenschaltung impliziert, dass die beiden Schalter, vorliegend also die Transistoren M1 und M2, in Reihe geschaltet sind, und zwar zwischen einem Potentialanschluss Vcc0 und einem zweiten Potentialanschluss, der vorliegend als Massenanschluss gezeichnet ist. An einem Potentialpunkt P zwischen den beiden Transistoren M1 und M2 ist die eigentliche Last R_{L} angeschlossen. Durch Steuerung der Schalter M1 und M2 wird das Potential am Potentialpunkt P bestimmt und damit über die Last R_{L} abfallende Spannungen bzw. über die Last R_{L} fließende Ströme.

Die Transistoren M1 und M2 sollen davor geschützt werden, durch Kurzschlussströme beschädigt bzw. zerstört zu werden. Solche Kurzschlussströme fließen bei ihrem Auftreten vom Potential Vcc0 über die beiden Transistoren M1 und M2 zu Masse. Durch Sperren eines der Transistoren M1 und M2 können somit diese Kurzschlussströme unterbunden werden. Hierfür ist es erforderlich, das Auftreten von Kurzschlussströmen zu erfassen. Hierfür ist in der Reinschaltung zwischen dem Potentialanschluss für Vcc0 und Masse eine Induktivität L vorgesehen. An Anschlüssen P1 und P2 zu beiden Seiten der Induktivität L wird die an der Induktivität L abfallende Spannung abgegriffen. Eine Spannung fällt an einer Induktivität dann ab, wenn sich die Stromstärke eines über die Induktivität fließenden Stroms ändert. Dies ist insbesondere während des Entstehens eines Kurzschlussstroms der Fall. Vorliegend soll ein Kurzschlussstrom während seines Entstehens anhand der an der Induktivität L abfallenden Spannung erkannt werden. Die an den Anschlüssen P1 und P2 abgegriffene Spannung wird daher einer Auswerteeinheit A zugeführt. Diese Auswerteeinheit A bewirkt nun, dass bei Erfülltsein eines vorbestimmten Kriteriums durch die abgegriffene Spannung der Schalter M2 gesperrt wird. Hierzu steuert die Auswerteeinheit A über eine Leitung LT1, die mit dem Gate des Transistors M2 verbunden ist, direkt den Transistor M2 an und bewirkt ein Sperren desselben. Alternativ teilt die Auswerteeinheit über eine Leitung LT2 einer Steuereinheit S für das Gate des Transistors M2 das Erfülltsein des vorbestimmten Kriteriums mit, und die Steuereinheit S steuert das Gate so an, dass der Transistor M2 sperrt. Bei der Steuereinheit S kann es sich um eine eigens bereitgestellte Steuereinheit oder um die ohnehin in der Halbbrückenschaltung zum Ansteuern des Transistors M2 vorgesehene Steuereinheit handeln.

Die Auswerteeinheit A kann wie die Steuereinheit S als Mikrocontroller bzw. Mikroprozessor ausgebildet sein. Diese können explizit die abgegriffene Spannung nach vorbestimmten Kriterien auswerten.

Besonders einfach und schnell arbeitet die Schaltungsanordnung aus Fig. 1 jedoch dann, wenn lediglich elektronische Bauelemente verwendet werden. Eine bevorzugte Ausführungsform der Schaltungsanordnung aus Fig. 1 mit elektronischen Bauelementen ist in Fig. 2 gezeigt.

Bei der Schaltungsanordnung aus Fig. 2 ist der Abgriff P2 an der Induktivität L über einen Widerstand R1 und eine Zenerdiode D mit einem Potentialpunkt P3 verbunden, der seinerseits über einen Widerstand R2 mit einem Potentialpunkt P4 verbunden ist. Der Potentialpunkt P4 kann unmittelbar mit dem Abgriff P1 gekoppelt sein, vorliegend ist eine Spannungsquelle V als dazwischengeschaltet gezeigt, an der beispielsweise eine Spannung von 12 V anliegt. Der Potentialpunkt P4 ist mit einem Hilfsversorgungspotential Vcc1 gekoppelt, das beispielsweise gegenüber Erde auf zwischen 5 und 20 V liegt. Parallel zum Widerstand R2 ist ein Kondensator C1 geschaltet. Der Potentialpunkt P4 ist mit dem Emitter eines ersten Hilfstransistors T1 gekoppelt, wobei dessen Basis mit dem Potentialpunkt P3 gekoppelt ist. Der Kollektor des Transistors T1 ist über eine Reihenschaltung aus einem Widerstand R4 und einem Kondensator C2 mit dem Potentialpunkt P1 gekoppelt. Optional ist wie vorliegend gezeigt parallel zu der Reihenschaltung aus Widerstand R4 und Kondensator C2 ein Widerstand R3 geschaltet. Der Potentialpunkt P5 zwischen dem Widerstand R4 und dem Kondensator C2 ist mit dem Gate eines zweiten Hilfstransistors, vorliegend eines MOSFETs gekoppelt. Dessen Source ist mit dem Potentialpunkt P1 gekoppelt, und sein Drainanschluss ist mit dem Gate des Transistors M2 gekoppelt. Das Gate des Transistors M2 ist im Übrigen von einer Steuereinheit S1 über einen Widerstand R5 ansteuerbar.

Die Schaltung funktioniert nun wie folgt:
Entsteht zwischen dem Potential Vcc0 und Masse über die Transistoren M1 und M2 ein Kurzschlussstrom, so steigt die Stromstärke eines über die Induktivität L fließenden Stromes stark an. Damit wird eine Spannung in der Induktiviät L erzeugt, die oberhalb eines Schwellwerts liegt, der durch die Zenerspannung der Zenerdiode D und die von der Spannungsquelle V abgegebene Spannung bestimmt wird. Bei Überschreiten dieses Schwellwerts sperrt die Zenerdiode D nicht länger, sondern es fließt ein Strom von dem Potentialanschluss Vcc1 über den Widerstand R2 und die Zenerdiode D und den Widerstand R1 zu Masse. Somit fällt am Widerstand R2 eine Spannung ab. Dadurch schaltet der Transistor T1 durch, und es fließt ein Strom über selbigen, z. B. vom Potentialanschluss Vcc1 über den Transistor T1, den Widerstand R1, die Induktivität L zu Masse, bzw. es fließt ein Strom aufgrund des Vorhandenseins der Spannungsquelle V. Beim Fließen eines Stroms über den Transistor T1 lädt sich nach und nach der Kondensator C2 auf. Die Kapazität des Kondensators C2 ist nun so gewählt, dass nach einer vorbestimmten Zeit eine solche Spannung am Kondensator C2 anliegt, dass der Transistor T2 durchschaltet. Dann wird über den Transistor T2 das Gate des Transistors M2 mit der Source desselben kurzgeschlossen, und der Transistor M2 sperrt.

Durch die Zenerdiode D, ggf. im Zusammenwirken mit der Stromquelle V, gibt es ein Schwellwertkriterium, ab wann ein Durchschalten des Transistors T2 eingeleitet wird. Der Widerstand R4 wirkt zusammen mit dem Kondensator C2 als Zeitglied, welches das Durchschalten des Transistors C2 verzögert: Erst muss der Kondensator C2 auf die entsprechende Spannung aufgeladen werden. Somit ist implizit für einen Kurzschlussstrom das Kriterium bereitgestellt, dass es eine zeitliche Änderung der Stromstärke gibt, die einen Mindestwert überschreitet, so dass eine Mindestspannung zwischen den Anschlüssen P1 und P2 überschritten wird. Durch das Zeitglied ist zusätzlich die Bedingung gesetzt, dass dieses Überschreiten des Schwellwerts durch die zeitliche Änderung der Stromstärke und damit der durch die Änderung induzierten Spannung für eine vorbestimmte Zeitdauer gilt. Allerdings ist diese Zeitdauer nicht festgelegt, sondern sie verkürzt sich, wenn der Stromanstieg besonders groß ist, weil dann der Kondensator C2 besonders schnell aufgeladen wird. Somit gibt es implizit eine ganze Schar von Stromanstiegsszenarien, bei denen der Transistor M2 gesperrt wird. Trotz des Vorhandenseins des Zeitglieds ist gewährleistet, dass das Sperren relativ kurzfristig erfolgt, so dass der im Entstehen begriffene Kurzschlussstrom die Transistoren M1 und M2 nicht beschädigen kann.

Die Erfindung wurde vorliegend für eine HalbbrückenSchaltung beschrieben. Sie ist auch bei Vollbrücken mit zwei Halbbrücken und bei mehrphasigen Systemen anwendbar, z.B. n-phasigen Brücken mit n Halbbrücken, wobei n eine natürliche Zahl größer als zwei ist. Bei mehreren Halbbrücken muss nicht für jede Halbbrücke ein eigenes induktives Element bereitgestellt werden, sondern es genügt ein einziges induktives Element, das in die gemeinsame Anschlussleitung zum Potentialanschluss eingefügt ist.

## Patentansprüche

1. Schaltungsanordnung mit zwei zwischen einem ersten Potentialanschluss und einem zweiten Potentialanschluss in Reihe geschalteten Halbleiterschaltern, insbesondere Transistoren (M1, M2), wobei ein induktives Element (L) in der Reihenschaltung zwischen den beiden Potentialanschlüssen angeordnet ist, und wobei Elemente einer Wirkkette derart angeordnet sind, dass bei vorbestimmten Bedingungen eine an dem induktiven Element (L) abfallende Spannung ein Abschalten, insbesondere Sperren zumindest eines der Halbleiterschalter (M2) bewirkt, **dadurch gekennzeichnet, dass**
- die Wirkkette eine Zenerdiode (D) umfasst
- eine Reihenschaltung aus der Zenerdiode (D) und einem Widerstandselement (R2) in einer Parallelschaltung zu dem induktiven Element (L) bereitgestellt ist, und
- zwei Anschlüsse eines ersten Hilfstransistors (T1) mit zwei Anschlüssen (P3, P4) des Widerstandselements (R2) gekoppelt sind derart, dass durch eine an dem Widerstandselement (R2) abfallende Spannung ein Durchschalten des ersten Hilfstransistors (T1) bestimmt wird, und
- die Wirkkette ein Zeitglied (R4, C2) mit einem kapazitiven Element (C2) umfasst, und
- einer (P4) der beiden Anschlüsse des ersten Hilfstransistors (T1) mit einem Potentialanschluss (Vcc1) gekoppelt ist sowie
- ein weiterer Anschluss des ersten Hilfstransistors über das kapazitives Element (C2) mit einem weiteren Potentialanschluss (P1) gekoppelt ist, so dass bei Anlegen einer Spannung an diese, letztgenannten Potentialanschlüsse und Durchschalten des ersten Hilfstransistors (T1) über selbigen ein Strom fließt, der das kapazitive Element (C2) lädt, und
- das kapazitive Element (C2) mit zweien seiner Anschlüsse (P1, P5) mit zwei Anschlüssen eines zweiten Hilfstransistors (T2) gekoppelt ist, so dass durch eine an dem kapazitiven Element (C2) abfallende Spannung ein Durchschalten des zweiten Hilfstransistors (T2) bestimmt wird,
wobei die Anschlüsse (P1) des zweiten Hilfstransistors (T2) so mit Anschlüssen eines Transistors (M2) der beiden in Reihe geschalteten Halbleiterschalter (M1, M2) gekoppelt sind, dass bei einem Durchschalten des Hilfstransistors (T2) dieser Transistor (M2) der beiden Halbleiterschalter gesperrt wird.

## Claims

1. Circuit arrangement having two semiconductor switches, in particular transistors (M1, M2), connected in series between a first potential connection and a second potential connection, an inductive element (L) being arranged in the series circuit between the two potential connections, and elements of an operative chain being arranged in such a manner that, in predetermined conditions, a voltage dropped across the inductive element (L) causes at least one of the semiconductor switches (M2) to be switched off, in particular disabled,
**characterized in that**
- the operative chain comprises a Zener diode (D),
- a series circuit comprising the Zener diode (D) and a resistance element (R2) is provided in a circuit in parallel with the inductive element (L), and
- two connections of a first auxiliary transistor (T1) are coupled to two connections (P3, P4) of the resistance element (R2) in such a manner that a voltage dropped across the resistance element (R2) determines connection of the first auxiliary transistor (T1), and
- the operative chain comprises a timer (R4, C2) having a capacitive element (C2), and
- one (P4) of the two connections of the first auxiliary transistor (T1) is coupled to a potential connection (Vcc1), and
- a further connection of the first auxiliary transistor is coupled to a further potential connection (P1) via the capacitive element (C2), with the result that, when a voltage is applied to these last-mentioned potential connections and the first auxiliary transistor (T1) is connected, a current flows via the latter and charges the capacitive element (C2), and
- two of the connections (P1, P5) of the capacitive element (C2) are coupled to two connections of a second auxiliary transistor (T2), with the result that a voltage dropped across the capacitive element (C2) determines connection of the second auxiliary transistor (T2),
the connections (P1) of the second auxiliary transistor (T2) being coupled to connections of a transistor (M2) of the two semiconductor switches (M1, M2) connected in series in such a manner that, when the auxiliary transistor (T2) is connected, this transistor (M2) of the two semiconductor switches is disabled.

## Revendications

1. Circuit comportant deux commutateurs semi-conducteurs montés en série entre une première connexion de potentiel et une deuxième connexion de potentiel, en particulier des transistors (M1, M2), un élément inductif (L) étant agencé dans le montage en série entre les deux connexions de potentiel, et des éléments d'une chaîne active étant agencés de manière telle que, dans des conditions prédéfinies, une tension en chute au niveau de l'élément inductif (L) provoque une coupure, et plus particulièrement un blocage d'au moins l'un des commutateurs semi-conducteurs (M2), **caractérisé en ce que** :
- la chaîne active comprend une diode Zener (D) ;
- un montage en série constitué de la diode Zener (D) et d'un élément de résistance (R2) est mis à disposition dans un montage parallèle à l'élément inductif (L) ; et
- deux connexions d'un premier transistor auxiliaire (T1) sont couplées à deux connexions (P3, P4) de l'élément de résistance (R2) de manière telle qu'une interconnexion du premier transistor auxiliaire (T1) est déterminée par une tension en chute au niveau de l'élément de résistance (R2) ; et
- la chaîne active comprend un organe temporisateur (R4, C2) comportant un élément capacitif (C2) ; et
- l'une (P4) des deux connexions du premier transistor auxiliaire (T1) est couplée à une connexion de potentiel (Vcc1) ; et
- une autre connexion du premier transistor auxiliaire est couplée à une autre connexion de potentiel (P1) via l'élément capacitif (C2), de sorte que, lors de l'application d'une tension à ces dernières connexions de potentiel et de l'interconnexion du premier transistor auxiliaire (T1), il passe par celui-ci un courant qui charge l'élément capacitif (C2) ; et
- l'élément capacitif (C2) est couplé en deux de ses connexions (P1, P5) à deux connexions d'un deuxième transistor auxiliaire (T2), de sorte qu'une interconnexion du deuxième transistor auxiliaire (T2) est déterminée par une tension en chute au niveau de l'élément capacitif (C2) ;
les connexions (P1) du deuxième transistor auxiliaire (T2) étant couplées de manière telle aux connexions d'un transistor (M2) des deux commutateurs semi-conducteurs (M1, M2) montés en série que, lors d'une interconnexion du transistor auxiliaire (T2), ce transistor (M2) des deux commutateurs semiconducteurs est bloqué.
